# EUROPEAN PATENT SPECIFICATION

(11) **EP 1 729 343 B1**
(45) Date of publication and mention of the grant of the patent: **30.11.2011**
(21) Application number: 06011142.4
(22) Date of filing: 30.05.2006
(51) Int. Cl.: H01L 23/498, H01L 23/373

(54) **A power semiconductor device**
Leistungshalbleiterbauteil
Dispositif à haute prestation

(30) Priority: 31.05.2005 JP 2005158289
(43) Date of publication of application: 06.12.2006
(73) Proprietor: HITACHI, LTD., Chiyoda-ku Tokyo 100-8280 (JP); HITACHI HARAMACHI ELECTRONICS CO., LTD., Hitachi-shi, Ibaraki 317-0072 (JP)
(72) Inventor: Toyoda, Yasushi, Tokyo 100-8220 (JP); Saito, Katsuaki, Tokyo 100-8220 (JP); Koike, Yoshihiko, Tokyo 100-8220 (JP); Ookubo, Shinji, Hitachi-shi Ibaraki 317-0072 (JP)
(74) Representative: Strehl Schübel-Hopf & Partner

(56) References cited:
- US-B1- 6 376 782

## Description

### BACKGROUND OF THE INVENTION

### [FIELD OF THE INVENTION]

The present invention relates to a semiconductor device that is highly reliable for repetitive temperature cycles in various modes assumed in practical use.

### [DESCRIPTION OF RELATED ART]

Power semiconductor modules in which a power semiconductor chip such as an insulated gate bipolar transistor (IGBT), diode, gate turn-off (GTO) thyristor, or transistors is sealed in an insulated case have been known. These chips are used in various inverter apparatus according to their rated voltage and current. Particularly, the IGBT can achieve highfrequency switching of high current, and thereby is advantageous in that control for a voltage controlled device is easy to perform. To secure safety and simplify mounting, an internally insulated structure, in which a heat dissipating metal plate and current carrying terminals are electrically insulated by an insulation The object of the invention is substrate, is used in many cases.

In an internally insulated power semiconductor module, circuit patterns are formed on both sides of the insulation substrate by using Cu and Al etc. Ni or another metal is used for plating to increase solderability, as necessary. In addition to the semiconductor chip, a metal terminal is joined on the circuit pattern so as to retrieve current to the outside of the power semiconductor module. Although wire bonding may be used for this joining, soldering is often performed. The heat dissipating metal plate on which the insulation substrate is mounted and circuit patterns on the bottom surface of the insulation substrate are often joined by soldering.

For the solders in the above soldering, cracks begin to develop mainly from the outer periphery at which stress is highest during temperature cycles in various modes conducted in actual use of the product. The cracks finally lead to breakage. Therefore, the life of the solder is very important for product reliability.

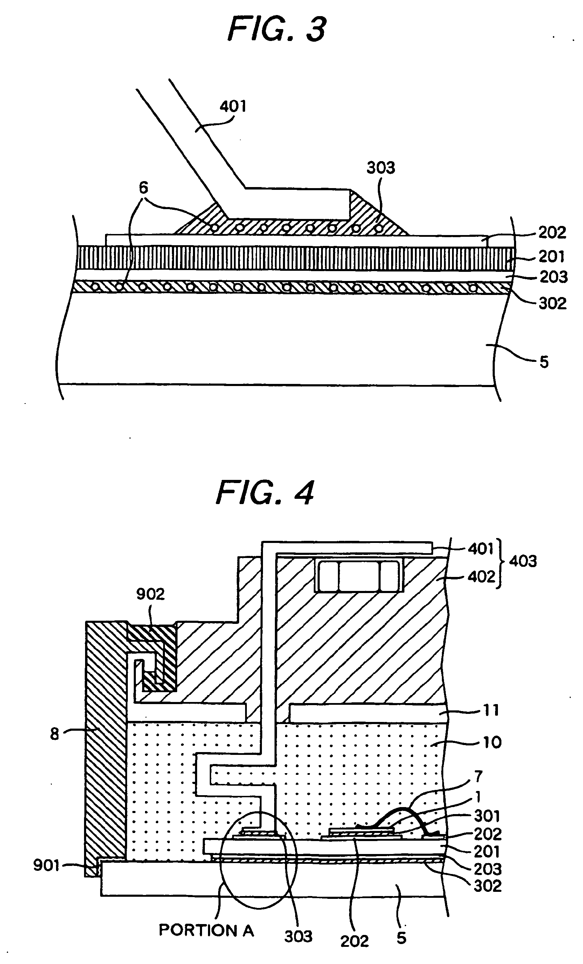

To reduce the stress applied to the solder, the solder joint must be thick to a certain extent. FIG. 3 illustrates an example in the prior art to have the solder joint thick; according to Patent Document 1, Ni balls 6 are included in a solder 303 to join a metal circuit pattern 202 and a metal terminal 401 to each other and in a solder 302 to join a metal circuit pattern 203 and a metal baseplate 5 to each other, the metallic circuit patterns 202 being formed on one side of an insulating substrate 201 and the metallic circuit pattern 203 being formed on the other side thereof and.

In US-B-6 376 782 a metal terminal is attached to an insulation substrate of a semiconductor device using a low melting point solder and a high melting point solder.

[Patent Document 1] Japanese Application Patent Laid-open Publication No. 2002-231883 (FIG. 16, description in paragraph [0057])

### SUMMARY OF THE INVENTION

In the method described in Patent Document 1, when the solders 303 and 302 melt, the Ni balls 6 move freely in the solders; this may cause the Ni balls 6 to be displaced locally and thus prevent them from being included evenly over the entire joined surface. As a result, unevenness in the thicknesses of the solders 302 and 303 become large, and reliability as a semiconductor module against the development of cracks during temperature cycles is lowered.

The purpose of the present invention is to provide a semiconductor device having highly reliable solder joints.

The invention provides a power semiconductor device according to claim 1 and a method of manufacturing a power semiconductor device according to claim 4.

In the present invention, two types of solders with different melting points are used to obtain a large solder thickness with a high melting point solder, cover the high melting point solder with a low melting point solder, and join a circuit pattern to a terminal or semiconductor device with a prescribed thickness.

A semiconductor device according to the present invention uses a solder with a high melting point to produce an uniform solder thickness, so solder life against fatigue fracture due to temperature cycles can be prolonged and variations in life can be lessened.

### BRIEF DESCRIPTION OF DRAWINGS

FIG. 1 illustrates a solder joint of an IGBT module in embodiment 1.
FIG. 2 illustrates a solder joint of an IGBT module in embodiment 2.
FIG. 3 illustrates a solder joint in the prior art.
FIG. 4 is a cross-sectional view of the structure of the IGBT module in embodiment 1.
FIG. 5 compares variations in the solder thickness in the IGBT module in embodiment 1 with those in the prior art.
FIG. 6 compares a failure rate in accelerated deterioration test of the IGBT module in embodiment 1 with that in the prior art.

### DETAILED DESCRIPTION OF THE INVENTION

In a power semiconductor module according to the present invention, a solder joint between a metal circuit pattern and metal terminal on an insulation substrate is formed by covering a high melting point solder that is joined on the metal circuit pattern and has a prescribed thickness with a low melting point solder and then joining the metal terminal by the low melting point solder. Usually, a semiconductor chip is solder-joined on a metal circuit pattern. At this time, therefore, the high melting point solder is first joined and a necessary solder thickness is obtained, after which the low melting point solder covers the high melting point solder so as to connect a metal terminal to the metal circuit pattern.

In the power semiconductor module of the present invention, the high melting point solder does not appear from an end of the low melting point solder, so cracks do not occur on the joint surface between the high melting point solder and low melting point solder even when the joint surface undergoes a temperature cycle.

Accordingly, the present invention can form highly reliable solder joints without having to increase the number of processes. Details of the present invention will be described with reference to the drawings.

### [Embodiment 1]

FIG. 4 shows part of the cross section of an IGBT module, which is a power semiconductor module in embodiment 1. As shown in FIG. 4, to assure insulation in the module, a semiconductor chip 1 such as an IGBT or diode, which is a power semiconductor chip, is connected by a solder 301 to a metal circuit pattern 202 joined on an insulation substrate 201. To increase the rated current of the module, a plurality of semiconductor chips 1 are mounted on the same insulation substrate 201 and connected in parallel with wires 7 made of aluminum or an aluminum alloy. Alternatively, a plurality of insulation substrates 201 are connected in parallel in the module. A metal circuit pattern 203 on the bottom surface of the insulation substrate 201 is joined to a metal baseplate 5 by a solder 302. The circuit in the module and a metal terminal 401 for external retrieval are connected to the metal circuit pattern 202 by a solder 303, as a terminal block 403 that is formed integrally with a plastic part 402 structured as a lid.

A plastic case 8 structured as the outer periphery of the module is bonded to the metal baseplate 5 through an adhesive 901; silicone gel 10 is supplied so as to assure insulation among the semiconductor chip 1, wire 7, and metal terminal 401 in the module. A spacing layer 11 is provided at the top of the inside of the module to absorb the expansion of the silicone gel 10 in the module. A hermetic seal is assured for the inside of the module by providing a hermetic seal with an adhesive 902 between the plastic part 402 of the terminal block 403 and the plastic case 8. The IGBT module structured as described above generates heat by itself due to a conduction during practical use, causing strain because of differences in the thermal expansion coefficients of individual portions. Particularly, during a temperature cycle in which heat generation and heat dissipation are repeated, strain is caused in joints of the solder, the wire, and the like.

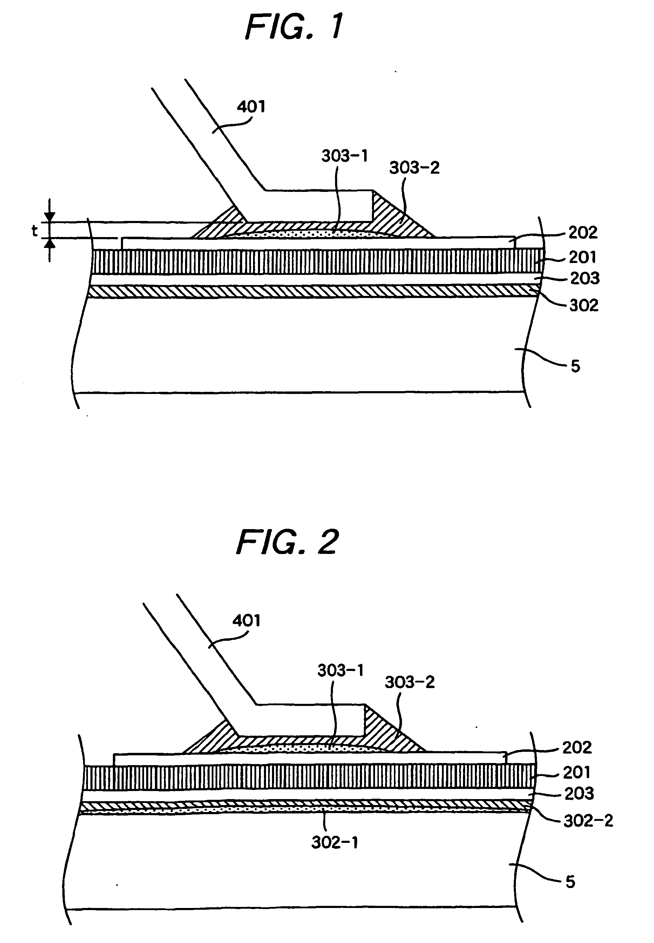

FIG. 1 is an enlarged view of portion A in FIG. 4. As shown in FIG. 1, there are a high melting point solder 303-1 formed on the metal circuit pattern 202 and a low melting point solder 303-2 formed on the high melting point solder 303-1 between the metal terminal 401 and metal circuit pattern 202 of the IGBT module in embodiment 1. Since the high melting point solder 303-1 does not appear from an end of the low melting point solder 303-2, cracks do not occur on the joint surface between the high melting point solder 303-1 and low melting point solder 303-2 even when the joint surface undergoes a temperature cycle.

In the IGBT module of embodiment 1, the high melting point solder 303-1 is first joined to the metal circuit pattern 202 as shown in FIG. 1. In this case, the thickness of the high melting point solder 303-1 is adjusted to a prescribed thickness necessary for the solder joint. Then, the metal terminal 401 is joined to the metal circuit pattern 202 by the low melting point solder 303-2 through the high melting point solder 303-1. The low melting point solder 303-2 is paste-like so as to adapt to variations in the shape of the metal terminal 401, and includes flux because the joining is performed while an oxidized layer formed on the surface of the high melting point solder 303-1 is removed.

If the joining temperature of the low melting point solder 303-2 is lower than the solidus line temperature of the high melting point solder 303-1, the surface of the high melting point solder 303-1 is integrated with the melt low melting point solder 303-2, and thus a superior joint is formed.

In addition, re-melting of the entire high melting point solder 303-1 does not occur, so the solder thickness at the first joining of the high melting point solder 303-1 remains nearly unchanged.

In the IGBT module in embodiment 1, the high melting point solder 303-1 is covered with the low melting point solder 303-2 as shown in FIG. 1 without an end of the high melting point solder 303-1 appearing from the low melting point solder 303-2.

In the IGBT module in embodiment 1, the thickness of the high melting point solder 303-1 is 100 to 300 µm, preferably 180 to 250 µm; the low melting point solder 303-2 is placed thereon. The thickness of the low melting point solder 303-2 that covers the convex portion of the high melting point solder 303-1 is 10 to 40 µm; the spacing between the metal circuit pattern 202 and metal terminal 401 is determined according to the height of the convex portion of the high melting point solder 303-1.

In the IGBT module in embodiment 1, since the high melting point solder 303-1 is covered with the low melting point solder 303-2 as described above, cracks due to thermal fatigue are not caused on the interface between the high melting point solder 303-1 and low melting point solder 303-2: only slight cracks appear at an end of the low melting point solder 303-2 which is directly in contact with the metal circuit pattern 202.

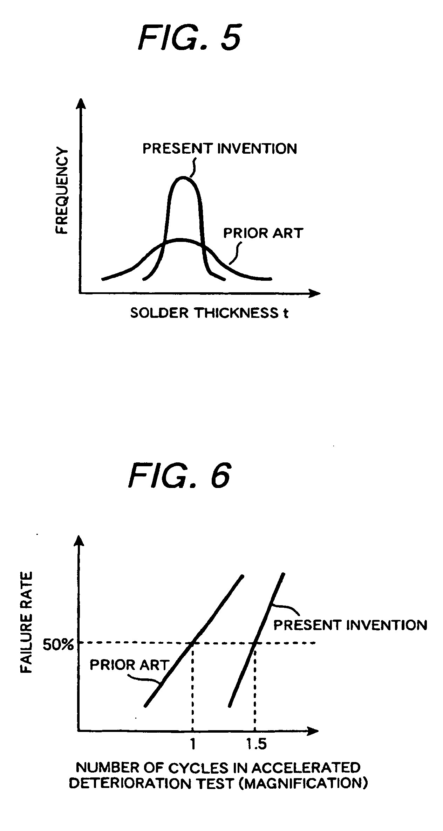

FIG. 5 illustrates comparison of variations in solder thickness "t" between the metal terminal 401 and metal circuit pattern 202 between embodiment 1 and the prior art in which Ni balls are distributed in a solder. The standard deviation of the solder thickness "t" in embodiment 1 can be reduced to one-third or less that of the prior art.

FIG. 6 shows a result of comparison of the number of cycles to module destruction in accelerated deterioration test between embodiment 1 and the prior art.

According to embodiment 1, the number of test cycles at the 50% failure rate at which half the modules under test are destroyed is increased by 1.5 times, and the standard deviation of the number of cycles to destruction is halved.

In the module in embodiment 1, when variations in temperatures allowed by manufacturing process are considered, the difference in the melting points between two types of solders, that is, between the high melting point solder 303-1 and low melting point solder 303-2 is preferably 10 °C or more. Examples of this combination of solder are shown below.
(1) High melting point solders
   (a) For Pb-Sn solders, 19 by weight percent > Sn > 0.1 by weight percent. At least one of In, Ag, Sb and Ge ingredients may be included slightly.
   (b) For Pb-In solders, 10 by weight percent > In > 0.1 by weight percent. Preferably, In ≥ 5 by weight percent. At least one of Sn, Ag, Sb and Ge ingredients may be included slightly.
   (c) For Pb-Ag solders, 4 by weight percent > Ag > 0.1 by weigh percent. At least one of Sn, In, Sb and Ge ingredients may be included slightly.
   (d) For Pb-Sb solders, 10 by weight percent > Sb > 0.1 by weight percent. At least one of Sn, In, Ag and Ge ingredients may be included slightly.
(2) Low melting point solders
   (a) Sn-Pb eutectic solders such as Sn-37Pb and Sn-50Pb.
   (b) Sn solders such as Sn-Ag-Cu, Sn-Cu, Sn-Sb, and Sn-In.

Embodiment 1 has been described for a case in which the semiconductor chip 1 is an IGBT or diode, but the same is true even when a power MOSFET is the semiconductor chip 1.

### [Embodiment 2]

Embodiment 2 will be described with reference to FIG. 2. As in FIG. 1, FIG. 2 is an enlarged view of portion A in FIG. 4. In an IGBT module in embodiment 2, in addition to the solder joint in embodiment 1, another solder joint is made between the metal baseplate 5 and metal circuit pattern 203 by using a high melting point solder 302-1 and low melting point solder 302-2. In the IGBT module in embodiment 2, the high melting point solder 302-1 is first joined to the metal baseplate 5 and then the metal circuit pattern 203 is joined by using the low melting point solder 302-2.

If the joining temperature of the low melting point solder 302-2 is lower than the solidus line temperature of the high melting point solder 302-1, the surface of the high melting point solder 302-1 is integrated with the melt low melting point solder 302-2, and thus a superior joint is formed.

In addition, re-melting of the entire high melting point solder 302-1 does not occur, so the solder thickness at the first joining of the high melting point solder 302-1 remains nearly unchanged, and solder joining is performed with a prescribed thickness.

Combination of the high melting point solder 302-1 and low melting point solder 302-2 in embodiment 2 is the same as in embodiment 1. Reduction in variations in the solder thickness "t", improvement in life to destruction, and reduction in variations in life to destruction can be predicted as in embodiment 1.

### [Embodiment 3]

In an IGBT module in embodiment 3, the semiconductor chip 1 and metal circuit pattern 202 in embodiment 1 shown in FIG. 4 are interconnected through a high melting point solder formed on the metal circuit pattern 202 and a low melting point solder formed on the high melting point solder in such a way that the high melting point solder does not appear from an end of the high melting point solder. Other aspects are the same as in embodiments 1 and 2. In embodiment 3, an IGBT module having highly reliable solder joints could also be created as in embodiments 1 and 2.

## Claims

1. A power semiconductor device including a semiconductor chip (1) having electrodes on the front and rear surfaces, an insulation substrate (201) on which the semiconductor chip (1) is mounted, a metal circuit pattern (202) provided on one of the upper and bottom surfaces of the insulation substrate, and a metal terminal (401) joined to the circuit pattern (202) by a solder member (303) which is a laminate of a plurality of solders having different melting points including
a first solder (303-1) with a high melting point soldered to the circuit pattern (202); and
a second solder (303-2) with a low melting point soldered to the circuit pattern (202) and covering the first solder (303-1) so that no part of the first solder (303-1) is exposed at the edges of the second solder (303-2).

2. The device of claim 1, wherein the high melting point solder (303-1) soldered to the circuit pattern (202) has a convex shape in the direction of the terminal (401).

3. The device of claim 1, wherein another metal circuit pattern (203) is provided on the other one of said upper and bottom surfaces of the insulation substrate (201) and is joined to a metal base plate (5) by another solder member (302) which is a laminate of a plurality of solders having different melting points consisting of a third solder (302-1) with a high melting point provided on the base plate (5), and a fourth solder (302-2) with a low melting point covering the third solder (302-1) and contacting the metal circuit pattern (203).

4. A method of manufacturing a power semiconductor device including a semiconductor chip (1) having electrodes on the front and rear surfaces, an insulation substrate (201) on which the semiconductor chip (1) is mounted, a metal circuit pattern (202) provided on one of the upper and bottom surfaces of the insulation substrate, and a metal terminal (401) joined to the circuit pattern by a solder member (303), the method comprising:
a first joining step of soldering a first solder (303-1) with a high melting point to the circuit pattern (202); and
a second joining step, executed after the first joining step, of soldering the terminal (401) to the circuit pattern (202) via the first solder (303-1) using a second solder (303-2) with a low melting point, whereby the second solder (303-2) covers the first solder (303-1) on the circuit pattern (202) so that no part of the first solder (303-1) is exposed at the edges of the second solder (303-2).

5. The method of claim 4, wherein the temperature of the second solder (303-2) in the second joining step is lower than the solidus line temperature of the first solder (303-1).

6. The method of claim 4, wherein the second solder (303-2) used in the second joining step is a paste-like solder including a flux.

## Patentansprüche

1. Leistungs-Halbleiterbauteil mit einem Halbleiterchip (1), der auf seiner vorderen und seiner hinteren Fläche Elektroden aufweist, einem Isoliersubstrat (201), auf dem der Halbleiterchip (1) montiert ist, einem auf der oberen oder der unteren Fläche des Isoliersubstrats vorgesehenen metallischen Schaltungsmuster (202) und einem mit dem Schaltungsmuster (202) über ein Lotelement (303) verbundenen metallischen Anschluß (401), wobei das Lotelement ein Laminat aus mehreren Loten mit unterschiedlichen Schmelzpunkten ist und aufweist:
ein auf das Schaltungsmuster (202) aufgelötetes erstes Lot (303-1) mit hohem Schmelzpunkt, und
ein auf das Schaltungsmuster (202) aufgelötetes zweites Lot (303-2) mit niedrigem Schmelzpunkt, das das erste Lot (303) derart bedeckt, daß von diesem kein Teil an den Kanten des zweiten Lots (303-2) frei liegt.

2. Bauteil nach Anspruch 1, wobei das auf das Schaltungsmuster (202) aufgelötete Lot (303-1) mit hohem Schmelzpunkt eine in Richtung des Anschlusses (401) konvexe Form hat.

3. Bauteil nach Anspruch 1, wobei auf der anderen der oberen und unteren Flächen des Isoliersubstrats (201) ein weiteres metallisches Schaltungsmuster (203) vorgesehen und mit einer metallischen Grundplatte (5) über ein weiteres Lotelement (302) verbunden ist, das ein Laminat aus mehreren Loten mit unterschiedlichen Schmelzpunkten ist, nämlich aus einem auf der Grundplatte (5) vorgesehenen dritten Lot (302-1) mit hohem Schmelzpunkt und einem das dritte Lot (302-1) bedeckenden und das metallische Schaltungsmuster (203) kontaktierenden vierten Lot (302-2) mit niedrigem Schmelzpunkt.

4. Verfahren zum Herstellen eines Leistungs-Halbleiterbauteils mit einem Halbleiterchip (1), das auf der vorderen und der hinteren Fläche Elektroden aufweist, einem Isoliersubstrat (201), auf dem der Halbleiterchip (1) montiert ist, einem auf der oberen oder der unteren Fläche des Isoliersubstrats vorgesehenen metallischen Schaltungsmuster (202) und einem mit diesem über ein Lotelement (303) verbundenen metallischen Anschluß (401), wobei
in einem ersten Verbindungsschritt ein erstes Lot (303-1) mit hohem Schmelzpunkt auf das Leitungsmuster (302) aufgelötet wird und
in einem nach dem ersten Verbindungsschritt ausgeführten zweiten Verbindungsschritt der Anschluß (401) des Schaltungsmusters (202) über ein erstes Lot (301-1) unter Verwendung eines zweiten Lots (303-2) mit niedrigem Schmelzpunkt aufgelötet wird, wobei das zweite Lot (303-2) das erste Lot (303-1) auf dem Schaltungsmuster (202) so bedeckt, daß von diesem kein Teil an den Kanten des zweiten Lots (303-2) frei liegt.

5. Verfahren nach Anspruch 1, wobei die Temperatur des zweiten Lots (303-2) in dem zweiten Verbindungsschritt niedriger ist als die Solidustemperatur des ersten Lots (303-1).

6. Verfahren nach Anspruch 4, wobei das in dem zweiten Verbindungsschritt verwendete zweite Lot (303-2) ein ein Flußmittel enthaltendes pastenartiges Lot ist.

## Revendications

1. Dispositif semi-conducteur de puissance comprenant une puce à semi-conducteur (1) ayant des électrodes sur les surfaces avant et arrière, un substrat isolant (201) sur lequel la puce à semi-conducteur (1) est montée, un tracé de circuit en métal (202) disposé sur une surface parmi la surface supérieure ou la surface inférieure du substrat isolant, et une borne en métal (401) jointe au tracé de circuit en métal (202) par un élément de soudure (303) qui est un stratifié de plusieurs soudures ayant différents points de fusion dont :
une première soudure (303-1) ayant un point de fusion élevé soudée au tracé de circuit (202) ; et
une deuxième soudure (303-2) ayant un point de fusion bas soudée au tracé de circuit (202) et recouvrant la première soudure (303-1) de manière à ce que aucune partie de la première soudure (303-1) ne soit exposée au niveau des bordures de la deuxième soudure (303-2).

2. Dispositif selon la revendication 1, dans lequel la soudure à point de fusion élevé (303-1) soudée sur le tracé de circuit (202) a une forme convexe dans la direction de la borne (401).

3. Dispositif selon la revendication 1, dans lequel un autre tracé de circuit en métal (203) est disposé sur l'autre surface parmi ladite surface supérieure et ladite surface inférieure du substrat isolant (201) et est joint à la plaque de base en métal (5) par un autre élément de soudure (302) qui est un stratifié de plusieurs soudures ayant différents points de fusion consistant en une troisième soudure (302-1) avec un point de fusion élevé pourvue sur la plaque de base (5) et une quatrième soudure (302-2) avec un point de fusion bas recouvrant la troisième soudure (302-1) et en contact avec le tracé de circuit en métal (203).

4. Procédé de fabrication d'un dispositif semi-conducteur comprenant une puce à semi-conducteur (1) ayant des électrodes sur les surfaces avant et arrière, un substrat isolant (201) sur lequel la puce à semi-conducteur (1) est montée, un tracé de circuit en métal (202) disposé sur une surface parmi la surface supérieure ou la surface inférieure du substrat isolant, et une borne en métal (401) jointe au tracé de circuit en métal par un élément de soudure (303), le procédé comprenant :
une première étape de jonction consistant à souder une première soudure (303-1) ayant un point de fusion élevé au tracé de circuit (202) ; et
une seconde étape de jonction, exécutée après la première étape de jonction, consistant à souder la borne (401) au tracé de circuit (202) par l'intermédiaire de la première soudure (303-1) à l'aide d'une deuxième soudure (303-2) ayant un point de fusion bas, où la deuxième soudure (303-2) recouvre la première soudure (303-1) sur le tracé de circuit (202) de manière à ce que aucune partie de la première soudure (303-1) ne soit exposée au niveau des bordures de la deuxième soudure (303-2).

5. Procédé selon la revendication 4, dans lequel la température de la deuxième soudure (303-2) dans la seconde étape de jonction est inférieure à la température de la ligne de solidus de la première soudure (303-1).

6. Procédé selon la revendication 4, dans lequel la deuxième soudure (303-2) utilisée dans la seconde étape de jonction est une soudure de type à la pâte à souder générant un flux.
